# EUROPEAN PATENT APPLICATION

(11) **EP 2 587 670 A1**
(43) Date of publication of application: **01.05.2013**
(21) Application number: 11186714.9
(22) Date of filing: 26.10.2011
(51) Int. Cl.: H03K 17/0412, H03K 17/12, H03K 17/16, H03K 17/18

(54) **Control contact driving system**

(71) Applicant: ABB Technology AG, 8050 Zürich (CH)
(72) Inventor: Slavov, Nedyalko, 8057 Zürich (CH); Schnell, Raffael, 5703 Seon (CH)
(74) Representative: ABB Patent Attorneys

(57) **Abstract**

The invention relates to a control contact driving system for a plurality of power semiconductor devices, comprising a current driver unit (1) adapted for providing reference currents for pulling-up and/or pushing-down the control contacts of the power semiconductor devices and a current distributor unit (3) adapted for amplifying and/or distributing the reference currents to the control contacts of the power semiconductor devices, whereby the current distributor unit (3) comprises a pull-up current mirror (2) comprising a plurality of PMOS based transistors and a push-down current mirror (2) comprising a plurality of NMOS based transistors, the first main contacts of all pull-up transistors are connected in parallel to a first voltage source and the first main contacts of all push-down transistors are connected in parallel to a second voltage source having a lower voltage than the first voltage source, the second main contact of a respective pull-up transistor and the second main contact of a respective push-down transistor are connected together and adapted for providing current to a respective control contact of a power semiconductor device, and the control contacts of the pull-up transistors are all connected in parallel to the current driver unit for receiving a pull-up current and the control contacts of the push-down transistors are all connected in parallel to the current driver unit for receiving a push-down current.

## Description

### Technical Field

The invention relates to a control contact driving system for a plurality of power semiconductor devices, comprising a current driver unit adapted for providing reference currents for pulling-up and/or pushing-down the control contacts of the power semiconductor devices and a current distributor unit adapted for amplifying and/or distributing the reference currents to the control contacts of the power semiconductor devices. The invention further relates to a power semiconductor module comprising the control contact driving system and a plurality of power semiconductor devices. The invention furthermore relates to a power semiconductor array comprising a plurality of modified power semiconductor modules and to a method for operating the control contact driving system, the power semiconductor module and/or the modified power semiconductor module.

### Background Art

Power semiconductor devices, such as insulated gate bipolar transistors (IGBT), reverse conductive insulated gate bipolar transistors (reverse conducting IGBT) and/or bi-mode insulated gate transistors (BIGT), are mostly used as a fast switching device for very high electrical currents and voltages. The popularity of IGBTs is rising due to their excellent electrical properties and relatively easy driving. They are widely used in applications like electrical motor control equipment, e.g. for hybride and electrical cars, locomotives, ship propulsions, industrial equipment, machineries etc., DC electrical transmission, such as DC-AC converters, wind and solar power converters and synchronizers, power network cosinus φ compesators, emergency power supplies etc.

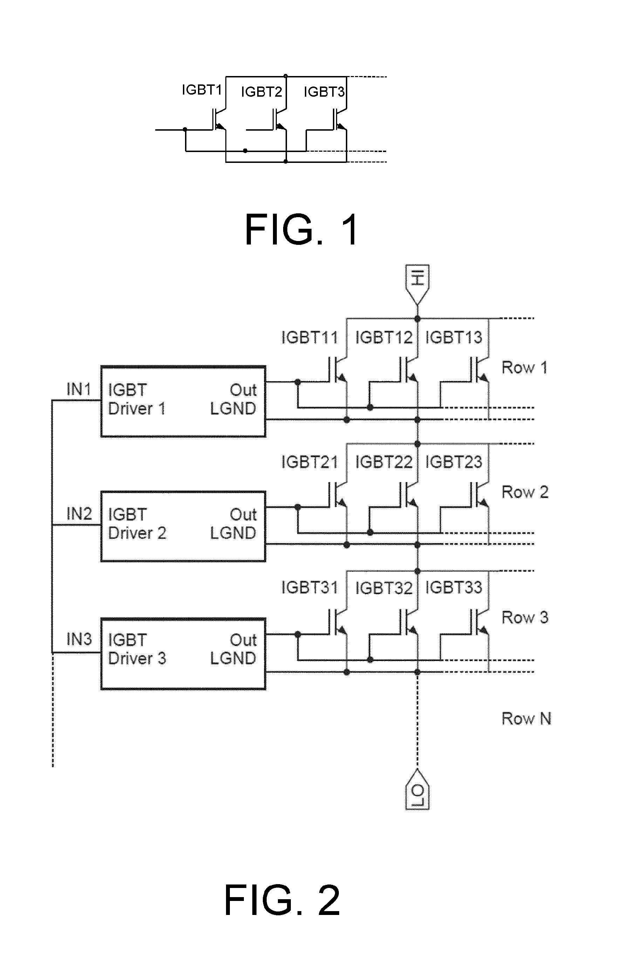

Very often, a plurality of IBGT dies are connected in parallel encapsulated in a module to increase their switching capabilities, as shown in prior art Fig. 1. A problem that appears in such parallel connection of the gates is that a defect in a gate and especially a short circuit connection between a gate and an emitter makes all of the IGBT devices in the module uncontrollable.

### Summary of invention

Therefore, it is object of the invention to provide the system for driving the control contacts of a plurality of power semiconductor devices, e.g. of IGBTs, such that a short circuit between a control contact and a main contact of a power semiconductor device, e.g. between a gate and an emitter of an IGBT, does not affect overall stability and/or controllability of the whole system.

This object is achieved by the independent claims. Further preferred embodiments are provided within the dependent claims.

Thus, the object is addressed by a control contact driving system for a plurality of power semiconductor devices, comprising a current driver unit adapted for providing reference currents for pulling-up and/or pushing-down the control contacts of the power semiconductor devices and a current distributor unit adapted for amplifying and/or distributing the reference currents to the control contacts of the power semiconductor devices, whereby the current distributor unit comprises a pull-up current mirror comprising a plurality of PMOS based transistors and a push-down current mirror comprising a plurality of NMOS based transistors, the first main contacts of all pull-up transistors are connected in parallel to a first voltage source and the first main contacts of all push-down transistors are connected in parallel to a second voltage source having a lower voltage than the first voltage source, the second main contact of a respective pull-up transistor and the second main contact of a respective push-down transistor are connected together and adapted for providing current to a respective control contact of a power semiconductor device, and the control contacts of the pull-up transistors are all connected in parallel to the current driver unit for receiving a pull-up current and the control contacts of the push-down transistors are all connected in parallel to the current driver unit for receiving a push-down current.

It is therefore an essential idea of the invention to provide current mirrors for further amplifying and/or distributing currents for switching the individual control contacts of a plurality of power semiconductor devices, for example amplifying and/or distributing positive and negative current pulses to the gates of a multi-die IGBT module. Such way, the control contact driving system provides for driving more than a single control contact respectively more than a single power semiconductor device. As the power semiconductor devices respectively the control contacts of the power semiconductor devices are driven individually, a failure of a control contact, e.g. a short circuit connection between a gate and emitter of an IGBT power semiconductor device, does not make all of the power semiconductor devices uncontrollable. The control contact driving system and/or the current driver unit can be implemented as a circuit, such as a hybride or even better integrated circuit, and preferably capsulated within the power semiconductor module, therefore in close contact to the controlled devices, e.g. transistors.

The control contact driving system provides for equal switching processes for all power semiconductor devices connected, for example connected in parallel, by providing equal driving currents to the control contacts of the power semiconductor devices, thereby avoiding the mismatch from using individual control contact drivers, as known from prior art. Preferably, all electrical devices used within the control contact driving system are provided with "well" matched electrical properties and placed in an equal environment in terms of temperature, supply voltage etc., such that the respective driving currents for the control contacts of the power semiconductor devices are also "well" matched.

In a preferred embodiment, the power semiconductor devices are provided as insulated gate bipolar transistor (IGBT), reverse conductive insulated gate bipolar transistor (reverse conducting IGBT), bi-mode insulated gate transistor (BIGT) and/or any other power MOSes known from prior art. The control contact is preferably provided as the gate, the first main contact is provided as the emitter and/or the second main contact is provided as the collector of the power semiconductor device, e.g. an IGBT. Preferably, the first voltage source provides a voltage greater than zero and/or the second voltage source provides a voltage smaller than zero or a voltage that is zero with respect to a main contact of the power semiconductor device, e.g. grounded to earth. In a further embodiment the current for pulling-up respectively the pull-up current comprises a current that is greater than zero and/or the current for pushing-down respectively the push-down current comprises a current that is smaller than zero. In regards to the pull-up transistors and/or the push-down transistors the control contact preferably comprises the gate, the first main contact comprises the source and/or the second main contact comprises the drain of the respective transistor. More preferably, before-mentioned transistors are provided as field effect transistors.

In a further preferred embodiment, the pull-up current mirror comprises a PMOS based pull-up reference transistor and the push-down current mirror comprises a NMOS based push-down reference transistor, the first main contact of the pull-up reference transistor is connected to all first main contacts of the pull-up transistors and the first main contact of the push-down reference transistor is connected to all first main contacts of the push-down transistors, the control contact of the pull-up reference transistor is connected to the control contacts of the pull-up transistors and the control contact of the push-down reference transistor is connected to the control contacts of the push-down transistors, and the second main contact of the push-up reference transistor is connected to the current driver unit for receiving the pull-up current and the second main contact of the push-down reference transistor is connected to the current driver unit for receiving the push-down current. Thus, according to this embodiment, the current, preferably current pulses coming from the current driver unit, are applied to the reference transistor, which is preferably in a "diode" connection for defining the bias voltage for the pull-up transistors respectively push-down transistors.

In an especially preferred embodiment the control contact driving system comprises a current sensor for detecting a malfunction of a control contact of a power semiconductor device, whereby the current sensor is connected to the first main contacts of the pull-up transistors and/or to the first main contacts of the push-down transistors. Such embodiment is advantageous for detecting shorted gates, as the current sensor is preferably adapted for measuring the value of the current flowing towards the current distributor unit and for activating an alarm etc. in case the value is greater than a predefined threshold.

In a further preferred embodiment, the pull-up current mirror comprises a plurality of PMOS based voltage limiting devices and the push-down current mirror comprises a plurality of NMOS based voltage limiting devices, at least one voltage limiting device is connected in serial with its main contacts between the pull-up transistor or the push-down transistor and the push-down respectively the pull-up transistor. Preferably, the voltage limiting device is provided as a cascoding transistor. Providing such voltage limiting devices respectively cascoding transistors allows for limiting the voltage across the transistor directly connected to the power semiconductor devices and for using low voltage CMOS technology for relatively high operating voltages.

The object of the invention is further addressed by a power semiconductor module comprising the control contact driving system as described before and a plurality of power semiconductor devices, whereby the control contact of a respective power semiconductor device is connected to the second main contact of a respective pull-up transistor and to the second main contact of a respective push-down transistor.

In another embodiment, the power semiconductor devices are arranged in groups such that the first main contacts of the power semiconductor devices of the respective group are all connected in parallel and such that the second main contacts of the power semiconductor devices of the respective group are all connected in parallel.

In a further embodiment, at least the second main contacts of a first group are connected to the first main contacts of a second group. Arranging the power semiconductor devices in such groups allows for switching higher voltages respectively currents.

According to another embodiment, the plurality of power semiconductor devices and the current distributor unit are bonded to a laminated substrate, whereby the current distributor unit is preferably implemented in CMOS or bipolar technology and mounted onto an IGBT module substrate.

In a further especially preferred embodiment, the power semiconductor device is provided as an IGBT. In another embodiment, the current distributor unit can be arranged external to the power semiconductor module.

The object of the invention is further addressed by a power semiconductor array comprising a plurality of modified power semiconductor modules comprising a plurality of power semiconductor devices, account driver unit adapted for providing reference accounts for pulling-up and/or pushing-down control contacts of the power semiconductor devices and a modified current distributor unit adapted for amplifying and/or distributing the reference currents to the power semiconductor modules, whereby the modified power semiconductor modules each comprise a plurality of power semiconductor devices and a current distributor unit adapted for amplifying and/or distributing the reference current to the power semiconductor devices, whereby the current distributor unit comprises a pull-up current mirror comprising a plurality of PMOS based transistors and a push-down current mirror comprising a plurality of NMOS based transistors, the first main contacts of all pull-up transistors are connected in parallel to a first voltage source and the first main contacts of all push-down transistors are connected in parallel to a second voltage source having a lower voltage than the first voltage source, the second main contact of a respective pull-up transistor and the second main contact of a respective push-down transistor are connected together with the respective control contact of a power semiconductor device, the control contacts of the pull-up transistors are all connected in parallel to the modified current distributor unit for receiving a pull-up current and the control contacts of the push-down transistors are all connected in parallel to the modified current distributor unit for receiving a push-down current, the modified current distributor unit comprises a plurality of PMOS based transistors and a plurality of NMOS based transistors, whereby the control contacts of the PMOS based transistors are connected together to the current driver unit for receiving the push-down current and the control contacts of the NMOS based transistors are connected together to the current driver unit for receiving the pull-up current, the second main contact of a respective PMOS based transistor is coupled to a respective modified power semiconductor module for providing the pull-up current and the second main contact of the respective modified power semiconductor module for providing the push-down current.

Further embodiments and advantages of the power semiconductor array are derivable for the man skilled in the art from before described control contact driving system and/or power semiconductor module.

The object of the invention is further addressed by a method for operating the control contact driving system as described before, the power semiconductor module as described before and/or the power semiconductor array, whereby the current driver unit alternatively provides a positive rectangular current as pull-up reference current followed by a negative rectangular current as push-down reference current. Providing such currents allow for "switching on" respectively "switching off" the control contact of the respective power semiconductor device.

According to another embodiment, the positive rectangular current comprises a rectangular current I₁ between t₁ and t₂ followed by a rectangular current I₂ between t₂ and t₃ followed by a rectangular current I₃ between t₃ and t₄, whereby I₁ ≥ I₃ ≥ I₂ and t₄ ≥ t₃ ≥ t₂ ≥ t₁, and the negative rectangular current comprises a rectangular current I₅ between t₆ and t₇ followed by a rectangular current I₆ between t₇ and t₈ followed by a rectangular current I₅ between t₈ and t₉, whereby I₅ ≥ I₆ and t₉ ≥ t₈ ≥ t₇ ≥ t₆. Using such rectangular current that succeed behind each other improves the switching algorithm for switching on respectively off the control contacts of the power semiconductor devices.

In another embodiment, the step of detecting a malfunction comprises providing a rectangular current I₄ between t₄ and t₅, whereby I₂ ≥ I₄ and t₅ ≥ t₄, and/or by providing a rectangular current I₇ between t₉ and t₁₀, whereby I₇ ≥ I₅ and t₁₀ ≥ t₉. Thus, after before-described "transition phase" between t₁ and t₄ a "detection phase" follows between t₄ and t₅ with a lower value I₄ for power saving, whereby I₄ preferably flows through the reference transistor and the voltage source. The same applies for t₉ and t₁₀.

### Brief description of drawings

The invention will be described in more detail hereinafter with reference to examples of embodiments, to which the invention is not limited.

Fig. 1 shows a prior art connection of a plurality of IGBTs in parallel,

Fig. 2 shows a prior art connection of the parallel IGBTs as shown in Fig. 1 in a serial connection with IGBT drivers,

Fig. 3 shows the so named Miller effect known from prior art,

Fig. 4 shows a simplified circuit and wave forms for the gate-emitter voltage and currents as known from prior art,

Fig. 5 shows an individual gate driving as known from prior art,

Fig. 6 shows the mismatch created by technological tolerances between drivers as known from prior art,

Fig. 7 shows three current levels during the transition phase as known from prior art,

Fig. 8 shows an embodiment of a current drive mode according to a preferred embodiment of the invention,

Fig. 9 shows a control contact driving system according to a preferred embodiment of the invention,

Fig. 10 shows the power semiconductor module according to a preferred embodiment of the invention,

Fig. 11 shows a possible placement of 4 IGBTs and 2 freewheeling diodes mounted on a substrate comprising the control contact driving system according to a preferred embodiment of the invention,

Fig. 12 shows a power semiconductor array according to a preferred embodiment of the invention,

Fig. 13 shows a preferred pull-up current and push-down current for operating the control contact driving system according to a preferred embodiment of the invention,

Fig. 14 shows a current sensor according to a preferred embodiment of the invention,

Fig. 15 shows a further preferred embodiment of the current distributor unit according to a preferred embodiment of the invention, and

Fig. 16 to 18 and 20 to 22 show simulation results achieved with control contact driving systems according to preferred embodiments of the invention as shown in Fig. 15 and 19, respectively, and

Fig. 19 shows another preferred embodiment of an implementation of a power semiconductor module comprising the control contact driving system.

### Detailed description of embodiments

A problem known from prior art, when using parallel connections of IGBTs capsulated in a module for increasing the switching capabilities, as shown in Fig. 1, is that a gate defect and especially a short circuit connection between a gate and an emitter makes all of the IGBT devices in the module uncontrollable. For improving of a blocking voltage capability, more modules may be connected in a serial connection as shown in prior art Fig. 2. In case of a defect in an IGBT, the overall system should continue to operate using the remaining IGBT devices with a slightly reduced current capability or to close all IGBT devices from corresponding rows and to continue to operate with respectively a slightly reduced blocking voltage capability. However, the parallel connection of the gates of the IGBTs makes such features impossible: A short circuit connection in one gate causes a voltage block for all other gates in the corresponding row. Prior art teaches different solutions for solving afore-mentioned problem.

Within a first solution, a shorted gate can be detected by the existence of gate current outside of the transition phase between switching on and off respectively off and on an IGBT device. However, the exact number of defected gates can not be detected with such group driving. In some cases the number of defected gates is an important information that has to be known.

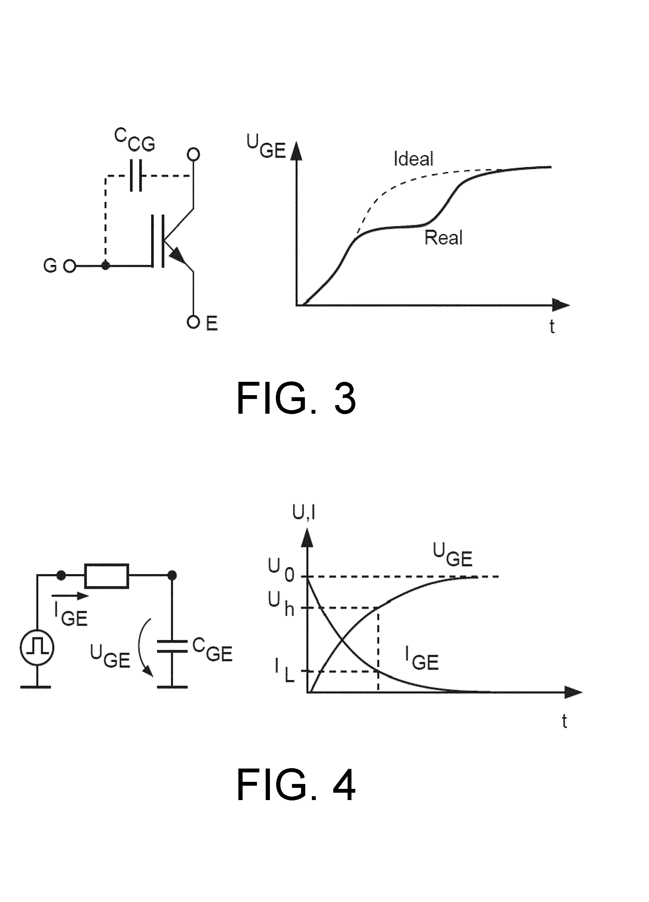

Another problem is the capacitive coupling between the collector and gate, the so named Miller effect, as shown in prior art Fig. 3. The capacitive coupling causes a voltage drop in the rising and falling signal edge and delays the commutation as shown in the figure.

The prior art voltage mode control with the gate resistor limiting the switching speed has a reduced immunity against the capacitive collector gate coupling due to the exponential decreasing of the current during the transition phase. The gates of the IGBTs behave as capacitors, while two resistors may be used for charging and discharging of the gates. Eventually one resistor may be used for both processes, as shown in prior art Fig. 4. The figure shows a simplified circuit and wave forms of the gate emitter voltage and current.

The gate voltage and current follows the equation V(t) = Vₒ * (1 - e^{-(t/RC)}), I(t) = Iₒ * e^{-(t/RC)}. As can be seen from Fig. 4, and also shown by the equation, the gate voltage rises, while the gate current reduces exponentially and after a certain value the gate may become sensitive for currents pushed through the reverse collector gate coupling.

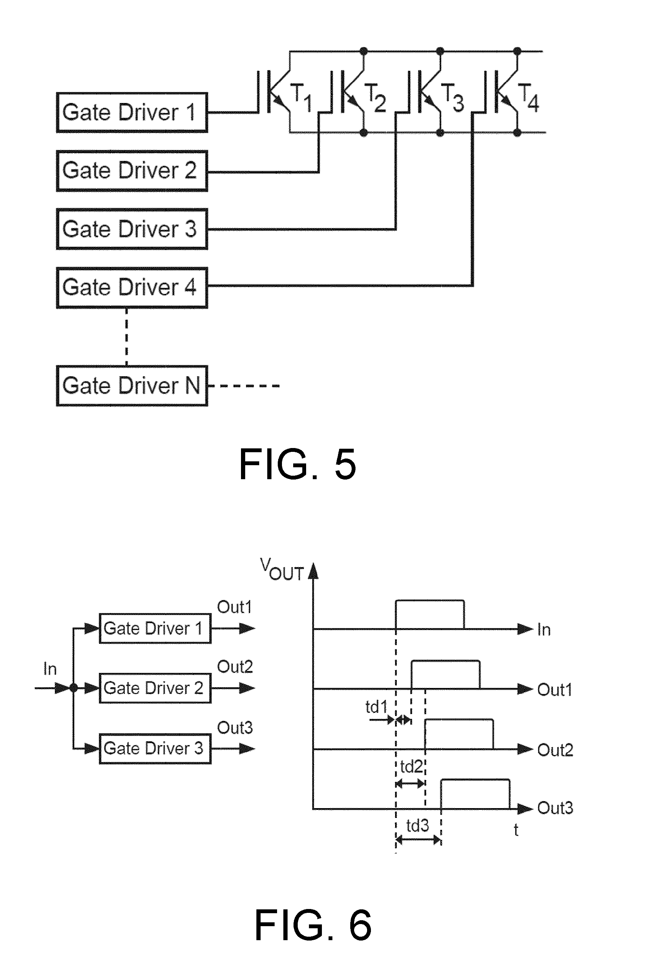

Prior art tried to address this problem by an individual gate driving as shown in prior art Fig. 5, whereby each gate has a dedicated gate driver. In case of failure in one gate, the remaining IGBT devices will continue to operate correctly. However, a problem in this configuration is the mismatch between the gate drivers: a gate driver usually comprises a complex application specific integrated circuit (ASIC) contenting a big amount of components. Therefore, the technological tolerances often cause a big mismatch between the drivers as shown in prior art Fig. 6.

Such mismatch causes different delays between the inputs and the outputs of the drivers which means that some IGBTs may open earlier than others, taking the whole load for a certain moment. This weakness reduces the reliability of the overall system due to the permanent overloading of these devices. A further problem is an increased price due to the big amount of gate drivers and corresponding connections required.

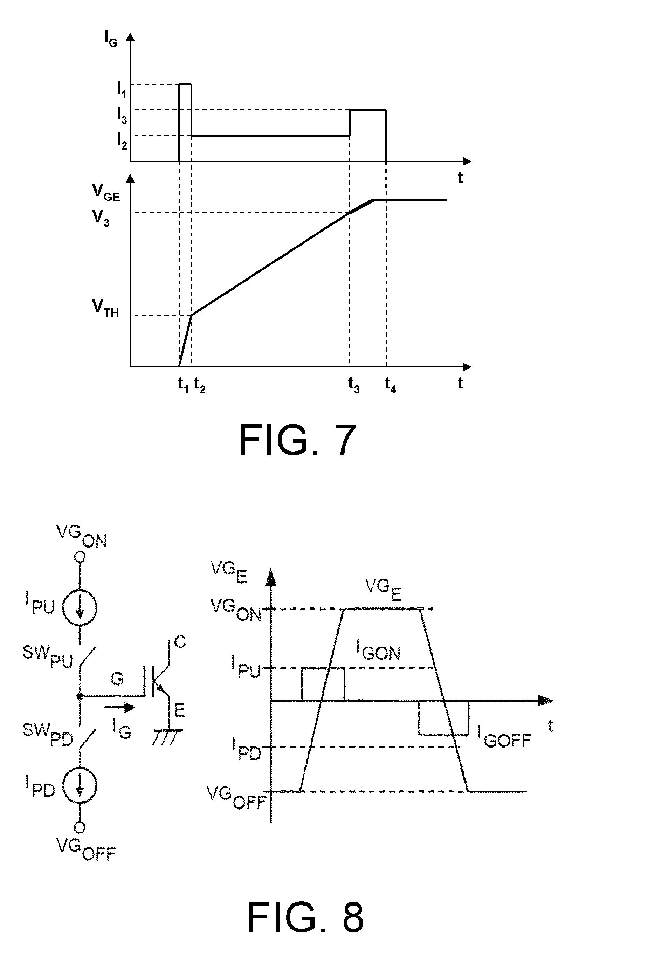

In a further solution, the applying of current mode reduces the negative influence of before described Miller effect. However, the problem with the mismatch between the drivers remains also with this solution. Another approach is the use of variable currents for realizing improved switching, for example three current levels during the transition phase between t₁ and t₄, as shown in prior art Fig. 7, for switching an IGBT between an off-state in t₁ to an on-state in t₄.

During an initial moment between t₁ and t₂, the gate driver pushes a higher current I₁ to the gate for faster achieving the gate threshold voltage V_{TH}. After this value, the IGBT starts to conduct and a current can be reduced to the value I₂ to limit the switching speed and respectively to protect the system from over-voltage in case of inductive load. When the gate voltage achieves a value V₃, where the reverse coupling increases its influence, i.e. the capacitive sinking of current from the gate, then the gate current can be increased to the value I₃ to compensate the current lost during the final moment.

The invention proposes a current driver unit 1 that, instead of voltage, uses a constant current for controlling the gate of an IGBT, whereby the currents are applied in difference directions depending from the operation, e.g. for turning on or turning off the IGBT. Fig. 8 shows an embodiment for the currents provided by the current driver unit 1.

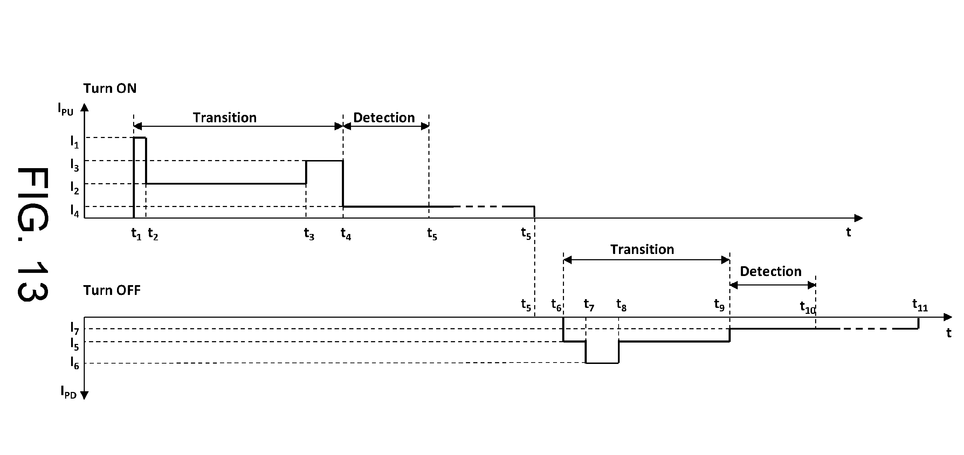

As can be seen, rectangular current pulses are used, a positive current pulse and a negative current pulse. These two current sources provide accurate currents for pulling-up and pushing-down the gate. Using such current driver unit 1, the gate voltage rises linearly with a constant speed. In other words, the currents applied to the gate causes the gate capacitance linearly raising or respectively falling voltages. The rising respectively falling voltage speed depends from the gate capacitance and the value of the pull-up and push-down currents and can be controlled by changing these currents. The charging and discharging currents have a constant value in an ideal case and exist during the transient phase only. When the gate voltage achieves the value close to the supply voltage, then the current stops the flow. The applying of constant currents thereby reduces the Miller effect, i.e. the effect of coupling between the collector and the gate. Thereby it is thoroughly possible to have more current sources and switches to provide a current shape as discussed lateron in Fig. 13.

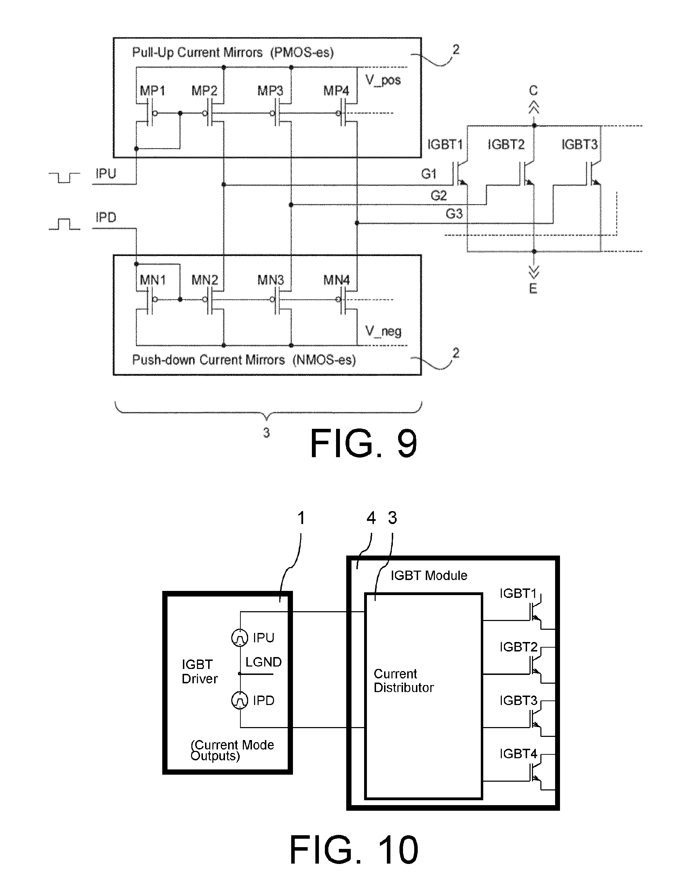

The main idea of the invention is to use two current mirrors 2 making up a current distributor unit 3 to further amplify and/or distribute the current pulses of the gates of a multi-die IGBT module. In such way, the control contact driving system can drive more than one gate respectively IGBT devices. The current mirrors 2 can be implemented as a circuit, e. g. as a hybride or integrated circuit, and can be encapsulated in the IGBT module, preferably provided close to the controlled IGBTs. Fig. 9 shows a preferred embodiment of the invention as described before.

The current pulses coming from the external IGBT driver, the current driver unit 1, are applied to NMOS based respectively PMOS based reference transistors MN1 and MP1. The reference transistors are in a "diode" connection and they define the bias voltage for the transistors MN2, MN3 etc. and MP2, MP3 etc.

Connecting the gate to the drain sets the operation point in the saturation area, because the drain-source voltage V_{DS} in this case is always above or equal to the saturation voltage V_{DSsat} = V_{GS} - V_{TH}. The transistors behave as current sources and their drain current can be figured out with the equation: l_{D} = (1/2) * µₙ * Cₒₓ * (W/L) * (V_{GS}- V_{TH})² * (1 + λ * (V_{DS} - V_{DSsat}), where µₙ is the charge-carrier effective mobility, Cₒₓ is the gate oxide capacitance per unit area, W is the gate width, L is the gate length, λ is channel-length modulation parameter and V_{DSsat} = V_{GS}- V_{TH}.

A current flowing through the drain of MN1/MP1 causes a V_{GS} satisfying the relation above. Because the same V_{GS} is applied to the other transistors, their drain currents depend from their W/L in respect to the W/L of the reference transistor, satisfying the relation below, given for the first 2 transistors MN2 and MP2: I_{DMN2}/I_{DMN1}= (W_{MN2}/L_{MN2}) / (W_{MN1}/L_{MN1}) or respectively I_{DMP2}/I_{DMP1}= (W_{MP2}/L_{MP2}) / (W_{MP1}/L_{MP1}).

Because of channel-length modulation, the current mirror 2 has a finite output resistance given by the ro of the output transistor: ro = 1 / (λ * I_{D}). The output resistance and respectively the current accuracy can be further improved utilizing cascoding techniques.

The current mirrors 2 can also amplify the input currents. As shown above, the amplification factor depends from the W/L ratio between the mirroring and the referencing transistors. In this case the external current driver unit 1 can have a low power outputs and respectively, the power amplification can be performed in the current distributor unit 3. Usual the current mirrors 2 are utilizing a uniform structure, e.g. MOS finger, repeated many times for a better matching and respective accuracy. This approach thus defines an integer amplification factor. The complete driving circuit 1, 3 will consist of two components, i.e. the current driver unit 1 and a power semiconductor module 4 comprising the current distributor unit 3, as shown in Fig. 10.

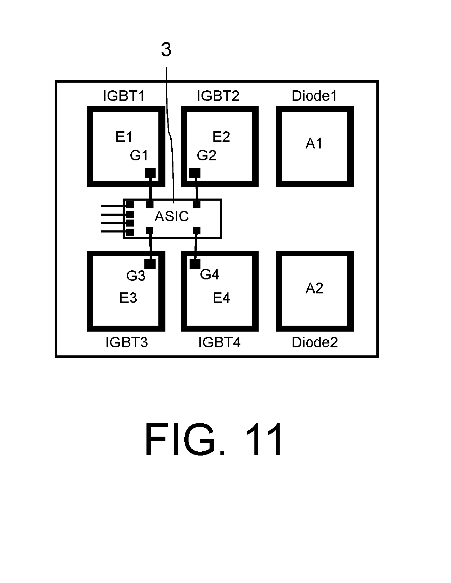

One possible placement in case of 4 IGBTs and 2 freewheeling diodes mounted on a common substrate is shown in Fig. 11.

The current driver unit 1 might be integrated in an ASIC, while in an alternative embodiment the current driver unit might also be placed external. The current distributor unit 3 is placed between the IGBTs. The gates G1 ... G4 are bonded to the ASIC. The ASIC is bonded to the laminated substrate and connected with metal tracks to the terminals, not shown in the figure. Four terminals are necessary, i.e. 2 inputs for pull-up and push-down currents, and 2 supplies. The emitters E1... E4 and anodes A1, A2 may be bonded to the substrate and connected to the power terminals or alternatively contacted, pressed or soldered, and connected from the upper side.

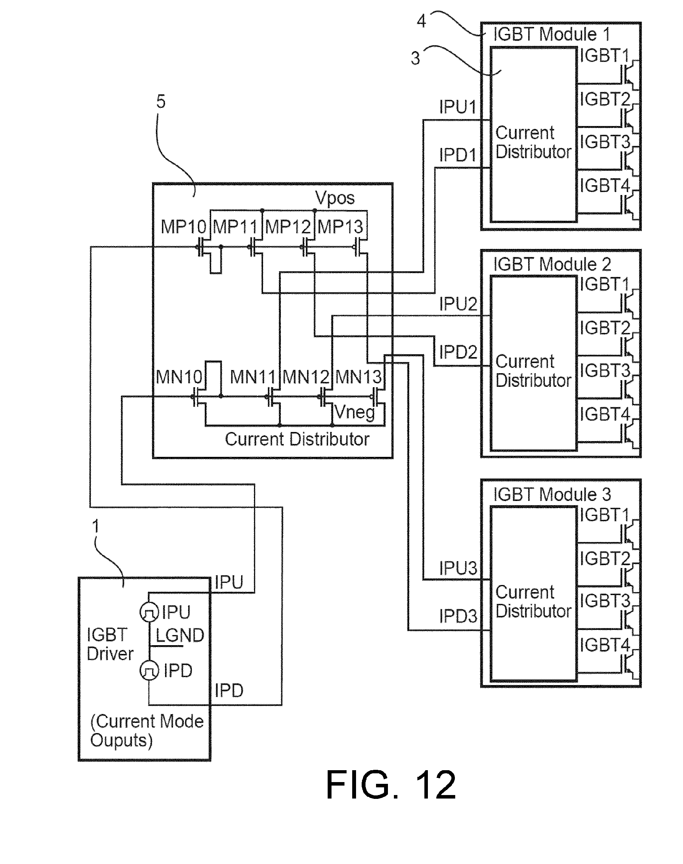

Another opportunity is the multilevel current distribution. For example a modified current distributor unit 5 may drive other current distributors units 3, integrated in the IGBT modules. A possible configuration is presented in Fig. 12 realising such power semiconductor array. This hierarchical implementation allows the driving of large IGBT arrays using a single driver.

To detect shorted gates, a current sensor 6 can be introduced in the power supply of the current distributor unit 3. The current sensor 6 measures the value of the current flowing towards the current distributor unit 3 and converts it in most of the cases to a proportional voltage. One or more comparators can compare the measured value to a reference value. Outside the transition phase, only the input current flows through the supply. A preferred waveform for the operating the control contact driving system, i.e. the pull-up and push-down currents, is shown in Fig. 13.

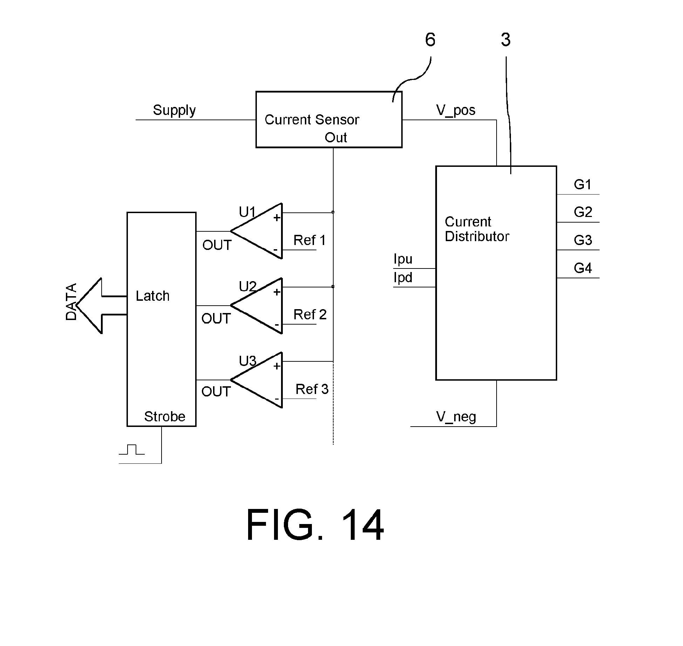

The transition phase implements the algorithm presented in Fig. 7. Alternatively the shape of the current pulse may be different depending from the used switching algorithm. In the simplest case the shape may be rectangular for a single current source. After the transition phase, the current applied to the current distributor unit 3 may be reduced to a lower value I₄ for power saving. The current I₄ flows through the reference transistor and the power supply. After the transition phase the gates are expected to be completely charged and they shouldn't consume current. In case of shorted gate or gates, the supply current is sum of the current I₄ and the short circuit current or currents. The total supply current is: I_{PS} = I₄ + N * (I₄ * A) where N is the number of the broken gates and A is the amplification factor of the current distributor unit 3. Several comparators can compare the measured value with properly selected reference values and in such way to detect the number of the broken gates. An example is presented in Fig. 14.

The strobe pulse has to be applied within the detection phase. The data are in the so called "thermometric code". The current sensor may have different implementations: resistor with differential amplifier, current transformer, hall sensor etc.

The functionality of the current distributor was proved by simulations using 2um CMOS technology. A small reference circuit implementing the standard method was used for a comparison.

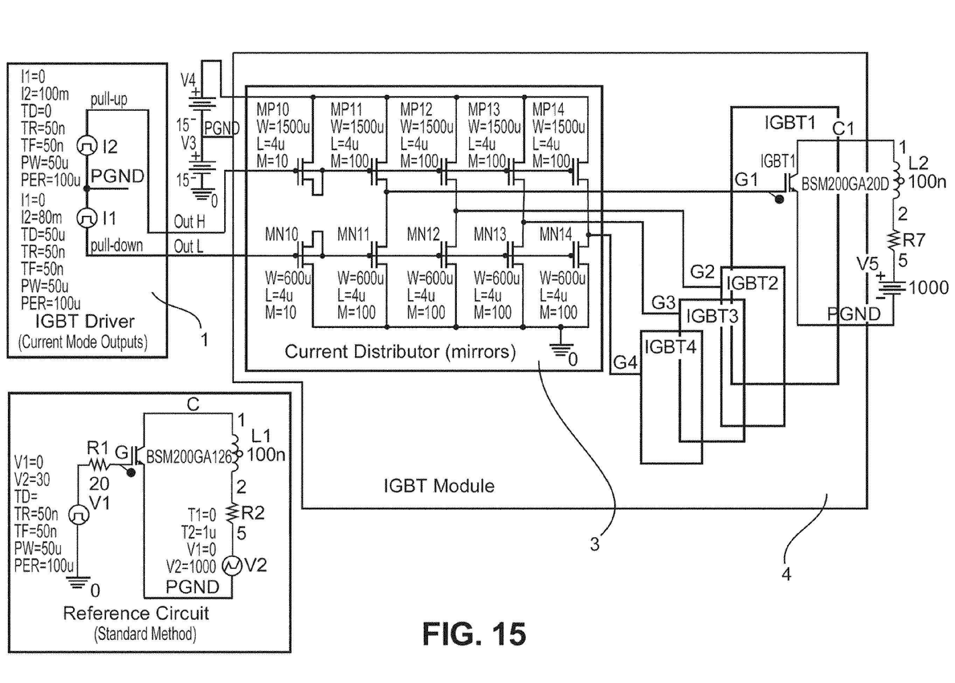

A further implementation of the current distributor is presented in Fig. 15. The schematic comprises the external IGBT driver 1 presented with current pulse sources I₁ and I₂. I₂ acts as pull-up output and I₁ respectively as push-down output. The current distributor unit 3 contents the PMOS current mirrors 2 implemented with MP10 to MP14 and NMOS current mirrors 2 implemented with MN10 to MN14. The PMOS current mirrors 2 perform the pull-up operation and the NMOS current mirrors 2 the push-down operation.

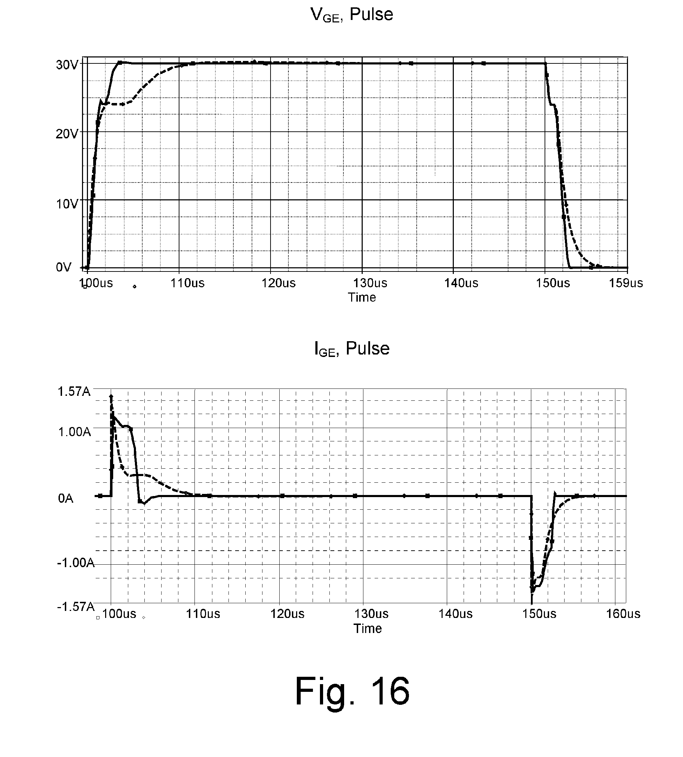

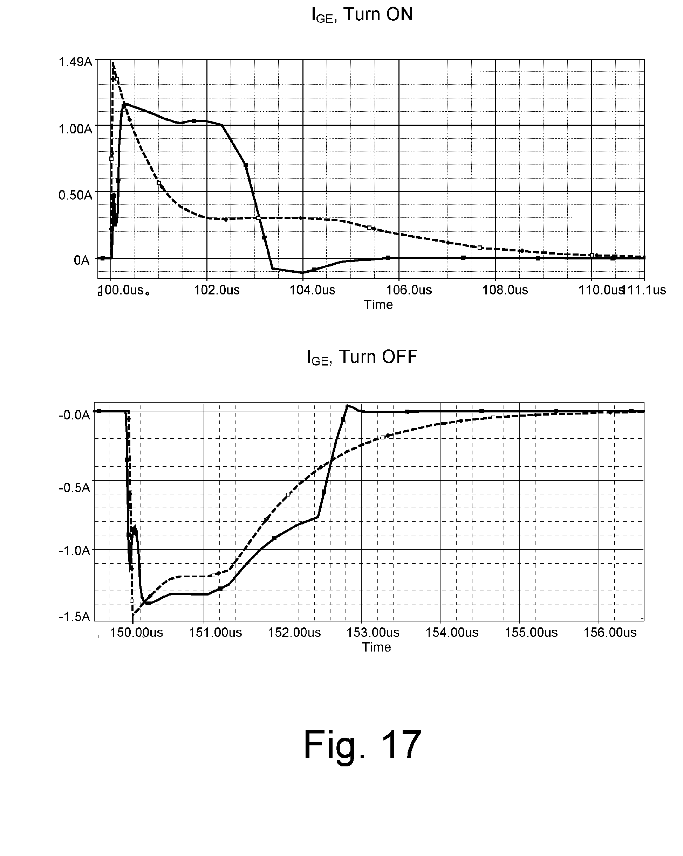

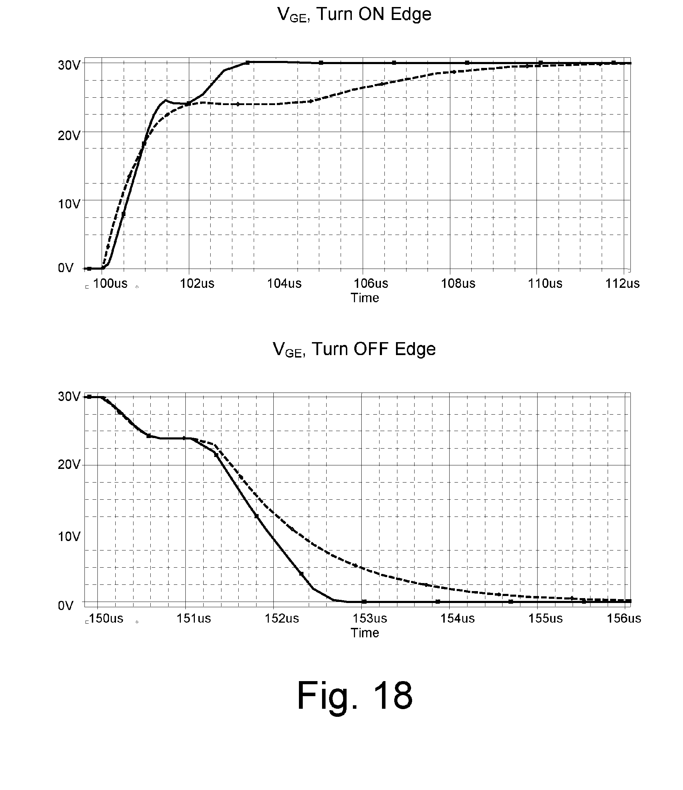

The simulation results using the control contact driving system are presented in Fig. 16 to 18. The dotted line presents the standard method. The solid line presents the proposed method according to the invention. In sum, the simulated result demonstrates an improved switching process with the presented method.

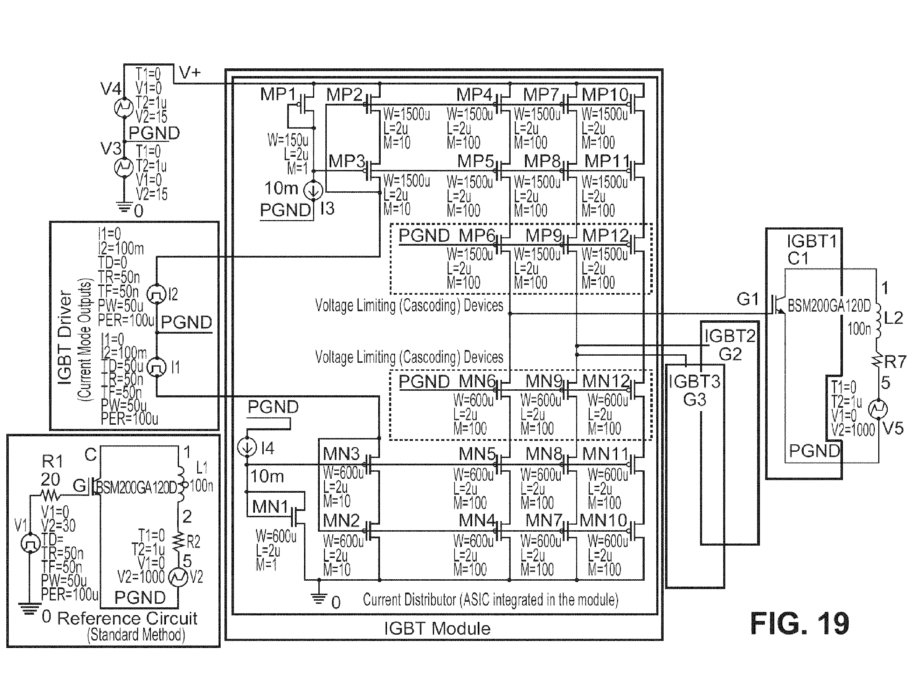

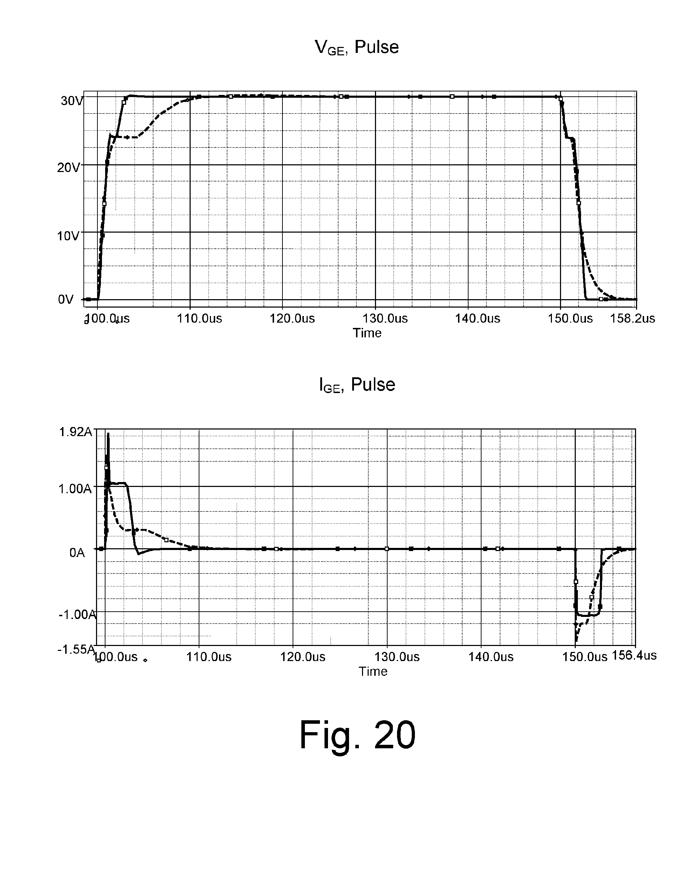

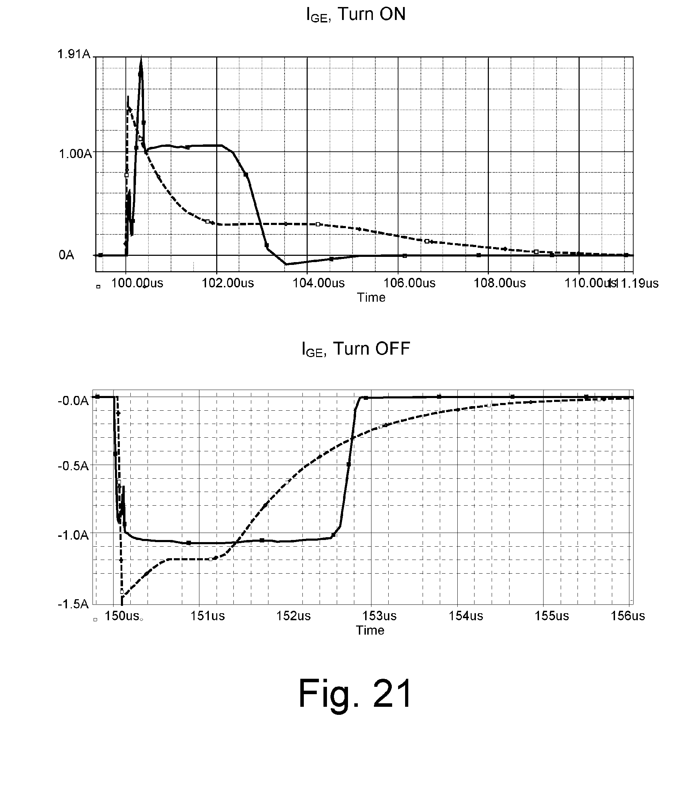

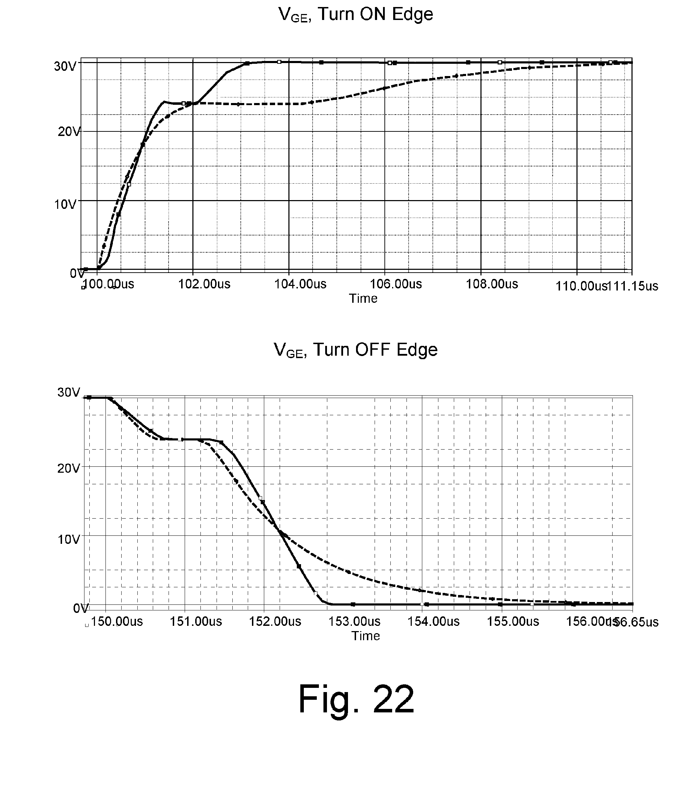

A more advanced circuit utilizing wide swing current mirrors 2 with improved characteristics and cascoding transistors allowing limiting of the voltage across the output transistors and respectively using of low voltage CMOS technology for relatively high operating voltages is presented in Fig. 19. The results by using this embodiment are given in Fig. 20 to 22 below. The waveforms of the standard method are presented as dotted lines. The solid line waveforms present the proposed method.

The embodiment from Fig. 19 demonstrates improved characteristics and especially more accurate current pulses, compared to the embodiment from Fig 15. Another advantage is that the voltage during the OFF state is distributed over 3 MOS transistors and it allows the using of low voltage CMOS technology. The low voltage MOS transistors have better matching between the devices due to the used self-centred gate technology.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

### Reference signs list

1 Current driver unit
2 Current mirror
3 Current distributor unit
4 Power semiconductor module
5 Modified current distributor unit
6 Current sensor

## Claims

**1.** Control contact driving system for a plurality of power semiconductor devices, comprising a current driver unit (1) adapted for providing reference currents for pulling-up and/or pushing-down the control contacts of the power semiconductor devices and a current distributor unit (3) adapted for amplifying and/or distributing the reference currents to the control contacts of the power semiconductor devices, whereby
the current distributor unit (3) comprises a pull-up current mirror (2) comprising a plurality of PMOS based transistors and a push-down current mirror (2) comprising a plurality of NMOS based transistors,
the first main contacts of all pull-up transistors are connected in parallel to a first voltage source and the first main contacts of all push-down transistors are connected in parallel to a second voltage source having a lower voltage than the first voltage source,
the second main contact of a respective pull-up transistor and the second main contact of a respective push-down transistor are connected together and adapted for providing current to a respective control contact of a power semiconductor device, and
the control contacts of the pull-up transistors are all connected in parallel to the current driver unit for receiving a pull-up current and the control contacts of the push-down transistors are all connected in parallel to the current driver unit for receiving a push-down current.

**2.** Control contact driving system according to the previous claim, whereby the pull-up current mirror (2) comprises a PMOS based pull-up reference transistor and the push-down current mirror (2) comprises a NMOS based push-down reference transistor,
the first main contact of the pull-up reference transistor is connected to all first main contacts of the pull-up transistors and the first main contact of the push-down reference transistor is connected to all first main contacts of the push-down transistors,
the control contact of the pull-up reference transistor is connected to the control contacts of the pull-up transistors and the control contact of the push-down reference transistor is connected to the control contacts of the push-down transistors, and
the second main contact of the pull-up reference transistor is connected to the current driver unit for receiving the pull-up current and the second main contact of the push-down reference transistor is connected to the current driver unit for receiving the push-down current.

**3.** Control contact driving system according to any of the preceding claims, comprising a current sensor (6) for detecting a malfunction of a control contact of a power semiconductor device, whereby the current sensor (6) is connected to the first main contacts of the pull-up transistors and/or to the first main contacts of the push-down transistors.

**4.** Control contact driving system according to any of the preceding claims, whereby the pull-up current mirror (2) comprises a plurality of PMOS based voltage limiting devices and the push-down current mirror (2) comprises a plurality of NMOS based voltage limiting devices, at least one voltage limiting device is connected in serial with its main contacts between the pull-up transistor or the push-down transistor and the push-down respectively the pull-up transistor.

**5.** Power semiconductor module (4) comprising the control contact driving system according to any of the preceding claims and a plurality of power semiconductor devices, whereby the control contact of a respective power semiconductor device is connected to the second main contact of a respective pull-up transistor and to the second main contact of a respective push-down transistor.

**6.** Power semiconductor module (4) according to the previous claim, whereby the power semiconductor devices are arranged in groups such that the first main contacts of the power semiconductor devices of the respective group are all connected in parallel and such that the second main contacts of the power semiconductor devices of the respective group are all connected in parallel.

**7.** Power semiconductor module (4) according to the previous claim, whereby at least the second man contacts of a first group are connected to the first main contacts of a second group.

**8.** Power semiconductor module (4) according to any of the preceding claims, whereby at least the plurality of power semiconductor devices and the current distributor unit are bonded to a laminated substrate.

**9.** Power semiconductor module (4) according to any of the preceding claims, whereby the power semiconductor device is provided as an IGBT.

**9.** Power semiconductor array comprising a plurality of modified power semiconductor modules comprising a plurality of power semiconductor devices,
a current driver unit (1) adapted for providing reference currents for pulling-up and/or pushing-down control contacts of the power semiconductor devices and a modified current distributor unit (3) adapted for amplifying and/or distributing the reference currents to the power semiconductor modules (4), whereby
the modified power semiconductor modules each comprise a plurality of power semiconductor devices and a current distributor unit (3) adapted for amplifying and/or distributing the reference currents to the power semiconductor devices, whereby
the current distributor unit (3) comprises a pull-up current mirror (2) comprising a plurality of PMOS based transistors and a push-down current mirror (2) comprising a plurality of NMOS based transistors,
the first main contacts of all pull-up transistors are connected in parallel to a first voltage source and the first main contacts of all push-down transistors are connected in parallel to a second voltage source having a lower voltage than the first voltage source,
the second main contact of a respective pull-up transistor and the second main contact of a respective push-down transistor are connected together with a respective control contact of a power semiconductor device,
the control contacts of the pull-up transistors are all connected in parallel to the modified current distributor unit for receiving a pull-up current and the control contacts of the push-down transistors are all connected in parallel to the modified current distributor unit for receiving a push-down current,
the modified current distributor unit (5) comprises a plurality of PMOS based transistors and a plurality of NMOS based transistors, whereby
the control contacts of the PMOS based transistors are connected together to the current driver unit for receiving the push-down current and the control contacts of the NMOS based transistors are connected together to the current driver unit for receiving the pull-up current,
the second main contact of a respective PMOS based transistor is coupled to a respective modified power semiconductor module for providing the pull-up current and the second main contact of the respective modified power semiconductor module for providing the push-down current.

**10.** Method for operating the control contact driving system, the power semiconductor module (4) and/or the power semiconductor array according to any of the respective preceding claims, whereby the current driver unit (1) alternatively provides a positive rectangular current as pull-up reference current followed by a negative rectangular current as push-down reference current.

**11.** Method according to the previous claim, whereby the positive rectangular current comprises a rectangular current I₁ between t₁ and t₂ followed by a rectangular current I₂ between t₂ and t₃ followed by a rectangular current I₃ between t₃ and t₄, whereby I₁ ≥ I₃ ≥ I₂ and t₄ ≥ t₃ ≥ t₂ ≥ t₁, and the negative rectangular current comprises a rectangular current I₅ between t₆ and t₇ followed by a rectangular current I₆ between t₇ and t₈ followed by a rectangular current I₅ between t₈ and t₉, whereby I₅ ≥ I₆ and t₉ ≥ t₈ ≥ t₇ ≥ t₆.

**12.** Method according to the previous claim and according to claim 3, comprising the step of detecting a malfunction by providing a rectangular current I₄ between t₄ and t₅, whereby I₂ ≥ I₄ and t₅ ≥ t₄, and/or by providing a rectangular current I₇ between t₉ and t₁₀, whereby I₇ ≥ I₅ and t₁₀ ≥ t₉.
